# EUROPÄISCHE PATENTSCHRIFT

(11) **EP 1 948 842 B1**
(45) Veröffentlichungstag und Bekanntmachung des Hinweises auf die Patenterteilung: **03.08.2011**
(21) Anmeldenummer: 06804390.0
(22) Anmeldetag: 16.11.2006
(51) Int. Cl.: C23C 16/36

(54) **TITANCARBONITRIDSCHICHT UND VERFAHREN ZUM HERSTELLEN EINER TITANCARBONITRIDSCHICHT**
TITANIUM CARBONITRIDE LAYER AND METHOD FOR THE PRODUCTION OF A TITANIUM CARBONITRIDE LAYER
COUCHE DE CARBONITRURE DE TITANE ET PROCEDE DE PRODUCTION D'UNE COUCHE DE CARBONITRURE DE TITANE

(30) Priorität: 17.11.2005 AT 18762005; 22.09.2006 AT 15852006
(43) Veröffentlichungstag der Anmeldung: 30.07.2008
(73) Patentinhaber: BOEHLERIT GmbH & Co.KG., 8605 Kapfenberg (AT)
(72) Erfinder: PITONAK, Reinhard, A-8600 Bruck/Mur (AT); GARCIA, Jose, A-1040 Wien (AT); WEISSENBACHER, Ronald, A-8600 Bruck/Mur (AT); RUETZ-UDIER, Klaus, A-8043 Graz (AT)
(74) Vertreter: Wirnsberger, Gernot
(86) Internationale Anmeldenummer: PCT/AT2006/000469
(87) Internationale Veröffentlichungsnummer: WO 2007/056785

(56) Entgegenhaltungen:
- EP-A- 1 160 353
- WO-A-2005/092608
- US-A- 6 146 697
- US-A1- 2002 102 403

## Beschreibung

Die Erfindung betrifft ein Verfahren zum Beschichten eines Werkzeuges oder Werkzeugteiles, insbesondere eines Schneidelementes wie eine Schneidplatte, bei dem ein Grundkörper bereitgestellt und auf diesem eine oder mehrere Schichten aufgebracht werden, wobei zumindest eine Schicht aus einem Titancarbonitrid gebildet wird, wobei das Abscheiden der Schicht aus Titancarbonitrid bei einer Temperatur des Grundkörpers von 850 bis 950 °C begonnen wird, wonach die Temperatur des Grundkörpers um zumindest 40 °C erhöht und das Abscheiden zumindest zeitweise bei erhöhter Temperatur fortgeführt wird.

Weiter betrifft die Erfindung eine auf einem Gegenstand aufgebrachte Beschichtung mit mindestens einer Titancarbonitridschicht.

Ferner betrifft die Erfindung ein Werkzeug oder Werkzeugteil, insbesondere Schneidelement wie eine Schneidplatte, umfassend einen Grundkörper mit einer oder mehreren auf diesem aufgebrachten Schichten, wobei mindestens eine Schicht eine Titancarbonitridschicht ist.

Abrasiv hochbeanspruchte Werkzeuge, beispielsweise Schneid-, Stanz- oder Umformwerkzeuge, werden üblicherweise beschichtet, um einem Verschleiß der Werkzeuge beim Gebrauch entgegenzuwirken. Dabei werden häufig auch mehrlagige Beschichtungen mit einer äußersten, werkstückseitigen Arbeitsschicht und mehreren darunterliegenden Schichten bzw. Lagen eingesetzt. Mehrlagige Beschichtungen sind zwar aufwändiger herzustellen als einlagige, jedoch bei gleicher Dicke weniger spröde und mit größerer Flexibilität verbunden, wenn es darum geht, eine Beschichtung bestmöglich im Hinblick auf zu erwartende Beanspruchungen auszulegen.

Aus dem Stand der Technik sind bei Schneidplatten von Drehwerkzeugen mehrlagige Beschichtungen bekannt, welche als äußerste, im Gebrauch werkstückseitige Schicht eine Titannitridschicht oder Aluminiumoxidschicht aufweisen, die unmittelbar oder mittelbar auf einer Metallcarbonitridschicht wie einer Titancarbonitridschicht abgeschieden ist. Die Aluminiumoxidschicht beispielsweise ist chemisch inert und hitzebeständig und schützt somit die darunterliegenden Schichten. Die unterstützende Titancarbonitridschicht ist durch eine große Härte gekennzeichnet und soll zu einer Verschleißfestigkeit der Beschichtung bzw. des Werkzeuges beitragen. Zwischen der verbindenden Schicht aus Titancarbonitrid und dem Grundkörper der Schneidplatte aus Hartmetall können weitere Schichten vorgesehen sein, insbesondere Schichten, welche am Grundkörper gut haften und so eine haftfeste Anbindung der Beschichtung ermöglichen.

Bei mehrlagigen Beschichtungen ist zu beachten, dass eine große Härte einzelner Schichten alleine für eine lange Gebrauchsdauer bzw. Standzeit noch nicht ausreichend ist. Selbst eine äußerst harte Schicht kann nicht mehr nützlich sein, wenn sie sich vom Grundkörper bzw. einer darunterliegenden Schicht löst, was insbesondere bei Schneidplatten auftreten kann, welche nicht nur hohen mechanischen Beanspruchungen, sondern auch hohen Temperaturen und/oder Temperaturwechseln ausgesetzt sind.

An Verbindungs- bzw. Zwischenschichten aus Metallcarbonitrid (MeCₓN_{y}) werden in diesem Zusammenhang besonders hohe Anforderungen gestellt, da ihre Funktion gerade darin besteht, der Beschichtung Verschleißfestigkeit zu verleihen und eine schützende Arbeitsschicht lange zu tragen.

Insbesondere Schichten aus Titancarbonitrid sind besonders häufig verwendete Verbindungsschichten in mehrlagigen Beschichtungen bzw. Schichtsystemen. Der Grund hierfür liegt darin, dass bei bekannten Titancarbonitridschichten Kohlenstoff lückenlos durch Stickstoff (bzw. umgekehrt) substituiert werden kann, womit auch die Eigenschaften dieser Schichten über die Zusammensetzung variabel eingestellt werden können. Letztlich haben solche Schichten Eigenschaften, welche zwischen jenen von Titancarbid und Titannitrid liegen bzw. eingestellt werden können. Solche Schichten sind beispielsweise aus der WO 2005/092608 A1 und der EP 1 160 353 A1 bekannt.

Eine Herstellung von Titancarbonitridschichten kann, wie dies viele Jahre Praxis war, mittels CVD-Verfahren (chemical vapour deposition) erfolgen, wobei die Schichten aus einem Methan, Stickstoff, Titantetrachlorid und Wasserstoff als Trägergas enthaltenden Gasgemisch bei Substrattemperaturen von 950 bis 1100 °C abgeschieden werden. Die so erhaltenen Titancarbonitridschichten sind aus globularem Korn aufgebaut und bilden eine dichte Schicht.

Im Zusammenhang mit der Abscheidung von diesem so genannten Hochtemperatur-Titancarbonitrid auf Hartmetallsubstraten wird oftmals eine unerwünschte Entkohlung des Substrates beobachtet und zwar auch dann, wenn zwischen Hartmetall und Titancarbonitridschicht eine Anbindungsschicht, zum Beispiel eine 0,5 µm dicke Schicht aus Titannitrid, vorgesehen wird. Um dieser Entkohlung Einhalt zu gebieten, ist man in jüngerer Zeit dazu übergegangen, für die Abscheidung von Titancarbonitrid Titantetrachlorid und Acetonitril enthaltende Gase zu verwenden, wodurch eine Abscheidungstemperatur auf niedrigere Temperaturen von 750 bis 900 °C gesenkt werden kann. So erzeugtes Titancarbonitrid ist als Mitteltemperatur-Titancarbonitrid bekannt und weist eine kolumnare Struktur aus stäbchenförmigen Kristalliten auf, deren Dicke mehr als 750 Å bzw. 75 Nanometer beträgt.

Bekannte Hochtemperatur- oder Mitteltemperatur-Titancarbonitridschichten dienen vornehmlich, wie erwähnt, als Verbindungsschichten, auf welchen weitere Schichten abgeschieden sind bzw. werden. Allerdings hat sich gezeigt, dass eine Haftfestigkeit von Titannitridschichten oder anderen Arten von Arbeitsschichten auf herkömmlichen Titancarbonitridschichten wie auch anderen Metallcarbonitridschichten unzureichend sein kann, so dass eine Gebrauchsdauer des Werkzeugs durch ein Ablösen einer an sich verschleißfesten Arbeitsschicht limitiert sein kann.

Daneben werden bekannte Titancarbonitridschichten und Metallcarbonitridschichten allgemein auch als äußerste, werkstückseitig angeordnete Schicht, also als Arbeitsschicht, eingesetzt. Dabei sind sie praktisch allerdings nur sehr beschränkt einsetzbar: Bei solchen Schichten ist bei Einsatz als Arbeitsschicht mit einem Auftreten von Aufklebungen und somit trotz großer Härte mit einer vergleichsweise geringen Gebrauchsdauer zu rechnen.

Hier setzt die Erfindung an und stellt sich die Aufgabe, ein Verfahren der eingangs genannten Art anzugeben, mit welchem eine Metallcarbonitridschicht aufgebracht werden kann, auf der einerseits weitere Schichten mit hoher Haftfestigkeit abgeschieden werden können und die andererseits hoch verschleißfest ist, so dass das beschichtete Werkzeug oder Werkzeugteil gegebenenfalls sofort eingesetzt werden kann.

Weiter ist es Ziel der Erfindung, eine auf einem Gegenstand aufgebrachte Beschichtung der eingangs genannten Art anzugeben, welche mindestens eine Metallcarbonitridschicht, beispielsweise Titancarbonitridschicht, aufweist, auf der einerseits weitere Schichten mit hoher Haftfestigkeit abgeschieden sind und die andererseits hoch verschleißfest ist, so dass das beschichtete Werkzeug oder Werkzeugteil gegebenenfalls sofort eingesetzt werden kann.

Ferner ist es ein Ziel der Erfindung, ein Werkzeug oder Werkzeugteil der eingangs genannten Art zu schaffen, bei dem die Metallcarbonitridschicht hoch verschleißfest ist und für eine hohe Haftfestigkeit einer darauf gegebenenfalls abgeschiedenen Schicht sorgt.

Das verfahrensmäßige Ziel der Erfindung wird durch ein Verfahren nach Anspruch 1 erreicht. Günstige Varianten eines erfindungsgemäßen Verfahrens sind Gegenstand der Ansprüche 2 bis 6.

Die mit der Erfindung erzielen Vorteile liegen insbesondere darin, dass eine Metallcarbonitridschicht, nämlich eine Titancarbonitridschicht, mit einem mikroskopischen Aufbau erzeugt wird, der sich exzellent zur Abscheidung weiterer Schichten mit fester Haftung eignet. Kristallchemisch betrachtet weisen die Kristalle jeweils eine inhomogene Elementverteilung über den Querschnitt auf. Die in der Folge aufgebrachten Schichten, beispielsweise aus Titannitrid, Aluminiumoxid oder Diamant haften auf solchen Schichten stark verbessert und ein Ablösen ist auch unter härtesten Einsatzbedingungen nicht gegeben oder tritt lediglich in stark verringerter Intensität auf.

Unerwartet wurde auch festgestellt, dass eine erfindungsgemäß abgeschiedene Schicht im Vergleich mit herkömmlichen Metallcarbonitridschichten auch ein ausgezeichnetes Verschleißverhalten zeigt und daher mit Vorteil auch als Arbeitsschicht einsetzbar ist. Diese Beobachtung ist noch überraschender, wenn man bedenkt, dass im Speziellen eine erfindungsgemäß abgeschiedene Titancarbonitridschicht bei gleicher chemischer Zusammensetzung eine geringere Härte (bzw. Mikrohärte) als eine auf herkömmlichen Weg erstellte Titancarbonitridschicht mit körnigem Aufbau ausweist.

Bei Durchführung des erfindungsgemäßen Verfahrens ist es von Vorteil, wenn die Temperatur des Grundkörpers unter fortschreitendem Abscheiden erhöht wird. Dadurch ist ein unterbrechungsfreies Wachsen der Metallcarbonitridschicht gegeben, was sich im Hinblick auf einen möglichst fehlerfreien Schichtaufbau als günstig erweist.

Um zu vermeiden, dass sich nach anfänglicher Bildung von Metallnitridkeimen bereichsweise eine Metallnitridschicht auszubilden beginnt, ist es zweckmäßig, dass die Temperatur des Grundkörpers innerhalb von 350 Minuten, insbesondere 120 Minuten, nach Beginn des Abscheidens auf erhöhte Temperatur gebracht wird.

Für eine hohe Beanspruchbarkeit der abgeschiedenen Metallcarbonitridschicht ist es von Vorteil, wenn nach Erreichen erhöhter Temperatur das Abscheiden für zumindest 60 Minuten fortgeführt wird, damit eine Mindestschichtdicke von zumindest 0,5 µm eingestellt wird.

Bevorzugt beträgt eine erhöhte Temperatur 1010 bis 1040 °C. In diesem Temperaturbereich wachsen die einzelnen Kristallite schnell und mit wenigen Fehlern, so dass ein schnelles Wachstum einer hoch beanspruchbaren Schicht resultiert.

Besonders vorzügliche Beschichtungen im Hinblick auf die Gebrauchseigenschaften des Werkzeuges oder Werkzeugteiles können erhalten werden, wenn mittels eines Methan, Stickstoff und Titantetrachlorid enthaltenden Gases eine Titancarbonitridschicht gebildet und abgeschieden wird. Im Zusammenhang damit hat es sich bewährt, wenn das Gas Methan, Stickstoff und Wasserstoff im molaren Verhältnis 1 :(8 bis 11):(15 bis 25) enthält und das Gas 1 bis 8 Volumenprozent Titantetrachlorid enthält. Dadurch können unerwünschte Anteile an körnigem Titancarbonitrid wesentlich verringert oder vermieden und die erfindungsgemäß erzielten Vorteile noch weiter gesteigert werden. Eine Zusammensetzung der Schicht beträgt in diesem Fall TiCₓN_{y} mit x gleich 0,15 bis 0,25 und y gleich 0,85 bis 0,75.

Ein Druck des reaktiven Gases ist an sich nicht kritisch und kann in weiten Grenzen variiert werden. Bevorzugt wird die Titancarbonitridschicht bei einem Druck von 100 bis 800 Millibar, vorzugsweise 200 bis 400 Millibar, abgeschieden.

Das weitere Ziel der Erfindung, eine auf einem Gegenstand aufgebrachte Titancarbonitridschicht anzugeben, die hoch verschleißfest ist und auf der gegebenenfalls weitere Schichten mit hoher Haftfestigkeit abscheidbar sind, wird erreicht, wenn die Metallcarbonitridschicht eine Nano-Komposit-Struktur aufweist, welche gemäß Anspruch 7 aus Kristallen mit inhomogener Elementverteilung gebildet ist.

Die mit der Erfindung erzielten Vorteile liegen insbesondere darin, dass eine Metallcarbonitridschicht mit Nano-Kompositstruktur, nämlich eine derartige Titancarbonitridschicht, mit einem mikroskopischen Aufbau vorliegt, der sich exzellent zur Abscheidung weiterer Schichten mit fester Haftung eignet.

Unter einer Nano-Komposit-Struktur der Schicht versteht der Fachmann eine Ausbildungsform mit mehreren Phasen, welche eine Abmessung im Nanobereich aufweisen.

Untersuchungen haben in überraschender Weise gezeigt, dass im Wesentlichen keinerlei Entkohlung im oberflächennahen Bereich des Substrates gegeben ist und von diesem auch kein Eindiffundieren der Bindephase in die Metallcarbonitridschicht erfolgte.

Die Komposit-Struktur mit einer Vielzahl von einzelnen Kristallen im Nano-Größenbereich ergibt auch eine wesentlich vergrößerte Korngrenzenfläche, wodurch die Zähigkeit der Schicht erhöht ist.

Weil beim Beschichten die Metallcarbonitridkristalle im Nano-Größenbereich aufgewachsen sind, ist die Oberfläche zerklüftet und bietet bei der Abscheidung einer weiteren Schicht strukturell gleichsam eine Vielzahl von kleinen, individuellen Spitzen oder Spießchen an, die für eine multiple Verankerung vorteilhaft sind. Die in der Folge aufgebrachten Schichten, beispielsweise aus Titannitrid, Aluminiumoxid oder Diamant haften daher stark verbessert und ein Ablösen ist auch unter härtesten Einsatzbedingungen nicht gegeben oder tritt lediglich in stark verringerter Intensität auf.

Unerwartet wurde auch festgestellt, dass eine erfindungsgemäß abgeschiedene Schicht im Vergleich mit herkömmlichen Metallcarbonitridschichten auch ein ausgezeichnetes Verschleißverhalten zeigt und daher mit Vorteil auch als Arbeitsschicht einsetzbar ist. Diese Beobachtung ist noch überraschender, wenn man bedenkt, dass im Speziellen eine erfindungsgemäß abgeschiedene Titancarbonitridschicht bei gleicher chemischer Zusammensetzung eine geringere Härte (bzw. Mikrohärte) als eine auf herkömmlichem Weg erstellte Titancarbonitridschicht mit körnigem Aufbau aufweist.

Wenn die Kristalle in ihrer chemischen Zusammensetzung im Zentrum und im Randbereich unterschiedliche Gehalte an Kohlenstoff und an Stickstoff besitzen, kann eine Schicht mit besonders guten Verschleißeigenschaften erstellt werden.

Die Zähigkeit und Haftfestigkeit der Metallcarbonitridschicht kann weiter gesteigert sein, wenn mindestens zwei Arten von Kristallen mit unterschiedlicher geometrischer Ausformung die Schicht bilden.

Sowohl die Festigkeit und Zähigkeit der Metallcarbonitridschicht selbst als auch eine Verbindung mit einer aufgewachsenen Schicht z.B. einer Titannitrid- oder Aluminiumoxidschicht können erhöht sein, wenn die Schicht aus mindestens einer Art mit sternförmig nadeliger Struktur und mindestens einer Art mit plättchenförmiger Struktur gebildet ist.

In einer Ausführungsvariante kann die Schicht aus Metallcarbonitrid mit Bor, Silicium, Zirkonium, Hafnium, Vanadium oder seltenen Erden dotiert sein, um beispielsweise eine Warmhärte der Schicht zu steigern. Unter dotiert sind in diesem Zusammenhang Einzelgehalte bis zu 0,01 Gew.-%, bezogen auf das Gesamtgewicht der Schicht, zu verstehen.

Besonders vorteilhaft ist es, wenn stäbchenförmige Kristallite im arithmetischen Mittel eine Dicke weniger als 65 Nanometer, vorzugsweise weniger als 45 Nanometer, aufweisen. Je feiner die Kristallite, desto besser kommt bei Abscheidung einer Schicht auf der erfindungsgemäßen Metallcarbonitridschicht ein Verankerungseffekt zum Tragen und umso größer ist eine Haftung der zusätzlich abgeschiedenen Schicht.

Nach einer bevorzugten Ausführungsform der Erfindung ist die mittlere Größe der Kristalle nach außen hin, also werkstückseitig erhöht. Derart wird einerseits eine hohe Verankerungsgüte der Metallcarbonitridschicht auf einem darunterliegenden Bereich, beispielsweise auf einem Hartmetall-Schneideinsatz eines Werkzeuges, erreicht, andererseits ist mit Vorteil auch ohne weitere Schichten eine lange Arbeitsdauer des Teiles erzielbar.

Nach der Erfindung hat eine Titancarbonitridschicht, die hoch verschleißfest ist und auf der gegebenenfalls weitere Schichten mit hoher Haftfestigkeit abgeschieden sind, eine Zusammensetzung TiCₓN_{y} mit x gleich 0,1 bis weniger als 0,3 und y gleich 0,9 bis mehr als 0,7.

Zumal Titannitrid im Vergleich mit Titancarbid eine wesentlich geringere Härte besitzt, war es für den Fachmann überraschend, dass ein erfindungsgemäßes Titancarbonitrid mit einem Kohlenstoffanteil von durchschnittlich weniger als 0,3 eine hoch verschleißfeste Schicht bildet und ein beschichtetes Werkzeug direkt praktisch, z.B. bei einer Abspanung von metallischem Werkstoff, mit hoher Lebensdauer einsetzbar ist.

Insbesondere für eine Titancarbonitridschicht ist es unerwartet, dass eine Mikrohärte einer erfindungsgemäßen Schicht nur etwa 2000 Hᵥ beträgt und somit wesentlich geringer ist, als jene herkömmlicher Titancarbonitridschichten, welche (mit steigendem Kohlenstoffgehalt) 2300 bis 3400 Hᵥ betragen können. Überraschend ist in diesem Bezug auch, dass trotz merklichem Kohlenstoffanteil in der Schicht Aufklebungen stark reduziert sind, was positiv zum Verschleißverhalten beiträgt.

Dabei kann die Gebrauchseigenschaft der Beschichtung ein Höchstmaß aufweisen, wenn die Werte x = 0,15 bis 0,20 und y = 0,85 bis 0,80 betragen.

Optisch ist eine erfindungsgemäße Metallcarbonitridschicht dadurch gekennzeichnet, dass die Farbe der Schicht einen gelb-rot Ton mit einer hell-dunkel Struktur, insbesondere mit einer dergleichen Aderstruktur aufweist, welche im Schliffbild am Lichtmikroskop auch bei Vergrößerung von 500 - 1000-fach erkennbar ist.

Das weitere Ziel der Erfindung, ein Werkzeug oder Werkzeugteil der eingangs genannten Art mit aufgebrachter Beschichtung zu schaffen, bei dem die Metallcarbonitridschicht hochfest verankert sowie verschleißfest ist und für eine hohe Haftfestigkeit einer gegebenenfalls darauf abgeschiedenen Schicht sorgt, wird dadurch erreicht, dass als Metallcarbonitridschicht eine Beschichtung gemäß einem der Ansprüche 7 bis 15 aufgebracht ist. Mit Vorteil ist nach außen hin, also werkstückseitig, die Carbonitridschicht sternförmig nadelig ausgeformt und trägt eine Deckschicht, gebildet als Oxidschicht, vorzugsweise eine Aluminiumoxidschicht (Al₂O₃) oder eine Kohlenstoffschicht, insbesondere Diamantschicht.

Vorteile eines erfindungsgemäßen Werkzeuges bzw. Werkzeugteiles bestehen insbesondere darin, dass die vorgesehene Titancarbonitridschicht einerseits verschleißfester als herkömmliche Metallcarbonitridschichten ist und andererseits bei Abscheiden einer weiteren Schicht auf der Metallcarbonitridschicht diese haftfest anbindet bzw. verankert, was sich ebenfalls als vorteilhaft für eine Gebrauchsdauer des Werkzeuges bzw. Werkzeugteiles erweist.

Wenngleich bei einem erfindungsgemäßen Werkzeug verschiedene Schichten beispielsweise als Arbeitsschichten auf der Titancarbonitridschicht aufgebracht sein können, wird eine besonders feste Haftung beobachtet, wenn eine Schicht aus einem Titanaluminiumnitrid aufgebracht ist. Auch Schichten aus Aluminiumoxid, Al₂O₃, oder Diamant können mit besonders guter Haftfestigkeit auf einer erfindungsgemäßen Titancarbonitridschicht aufgebracht sein.

Weitere Vorteile und günstige Wirkungen eines Werkzeuges gemäß der Erfindung ergeben sich aus dem Zusammenhang der Beschreibung und den nachfolgenden Ausführungsbeispielen, anhand derer die Erfindung noch weitergehend beschrieben ist.

Es zeigen:
Fig. 1 ein REM-Photo der Oberfläche einer erfindungsgemäßen Ti(CN)-Schicht (REM - Raster-Elektronen-Mikroskopie);
Fig. 2 ein Bild einer TEM-Untersuchung (TEM - Transmissions-Elektronen-Mikroskopie);
Fig. 3 ein Schliffbild des Überganges einer Beschichtung (Schliffprobe im Winkel von 15° angeschliffen);
Fig. 4 eine Darstellung einer experimentell ermittelten Verschleißmarkenbreite V_{b} in Abhängigkeit einer Schnittanzahl für Wendeschneidplatten mit verschiedenen Beschichtungen;
Fig. 5 eine schematische Darstellung des Temperaturverlaufes während eines Beschichtens.

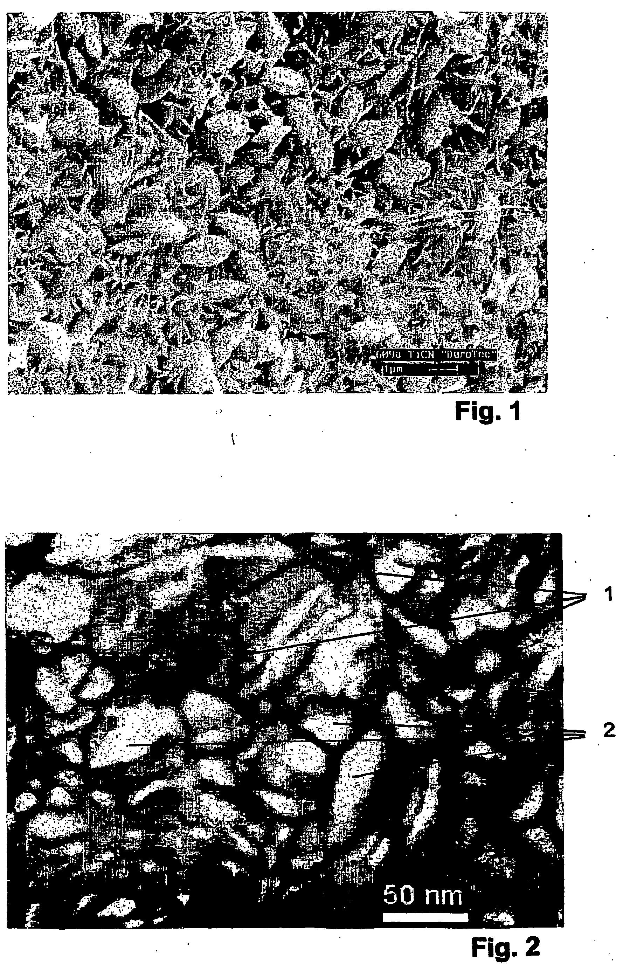

In Fig. 1 ist eine REM-Aufnahme der Oberfläche einer erfindungsgemäßen Titancarbonitridschicht wiedergegeben. Die Schicht ist auf dem Substrat in einer Komposit-Struktur mit sternförmigen Nadeln und eingebettet in diesen dickere Plättchen aufgewachsen. Die Plättchen besitzen eine größte Längserstreckung von etwa 1 µm, sind flach und haben eine Breite im Durchschnitt von etwa 0,7 µm, hingegen sind die sternförmigen Nadeln mit einer wesentlich geringeren Dicke ausgebildet. Die plättchen-und nadelförmigen Kristalle weisen eine inhomogene Elementverteilung auf und besitzen auch im Vergleich verschiedene Durchschnittszusammensetzung.

Die Ausformung einer derartig strukturierten Oberfläche einer Metallcarbonitridschicht bietet beste Bedingungen für eine hohe Haftfestigkeit einer aufgebrachten Folgeschicht.

Zur Identifizierung der kristallinen Phasen in der Schicht wurden Untersuchungen mittels Röntgendiffraktion unter Verwendung von CuK-Strahlung herangezogen. Auswertungen der XRD Messungen erbrachten bei einer erfindungsgemäßen Schicht ein C/N Verhältnis im Bereich von C/N = 0,14 bis 0,19/0,86 bis 0,81.

Eine nach Scherrer bestimmte mittlere Korngröße ergab Werte von 26 und 17 nm. Die Schicht weist also eine Nano-Struktur auf.

Aus Fig. 2 einer TEM-Aufnahme sind dunkle Bereiche mit der Bezeichnungen 1 und helle Bereiche mit dem Bezugszeichen 2 erkennbar. In den Untersuchungen dieser Probe sind im Vergleich die dunklen Bereiche reicher an Kohlenstoff und die hellen Bereiche reicher an Stickstoff. Deutlich ist dadurch eine Entmischung bezüglich der Zusammensetzung der Körner zu sehen, was eine spezifische Kern-Mantel-Struktur der Körner offenbart.

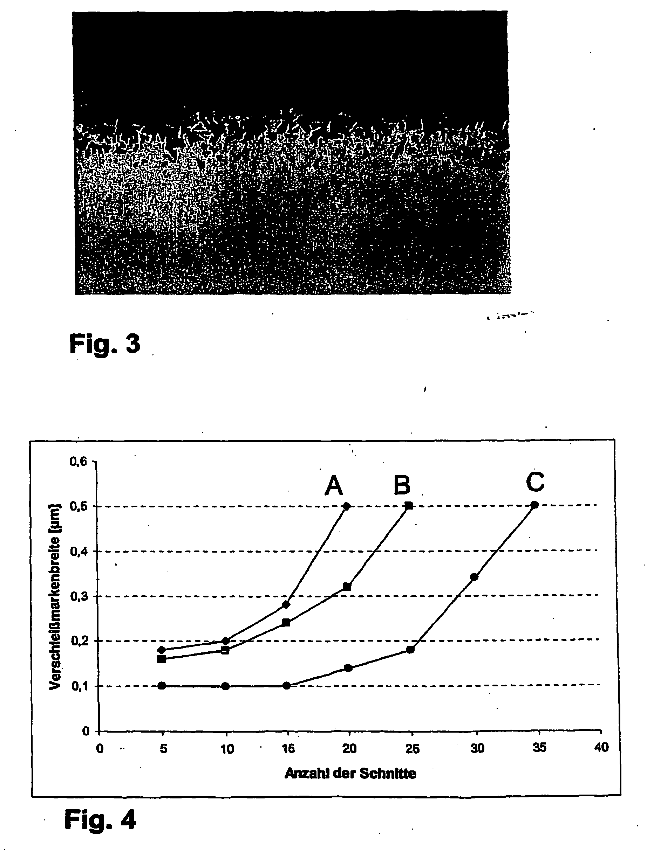

Am Übergang zu einer nachträglich abgeschiedenen Arbeitsschicht ist die freie Oberfläche einer erfindungsgemäßen Titancarbonitridschicht stark zerklüftet und nadelig ausgebildet (Fig. 3). Diese Oberflächenstruktur begünstigt ein haftfestes Abscheiden nachfolgender Schichten, da es zu einer innigen Durchdringung der Schichten im Grenzbereich kommt. Dabei ist eine Abweichung einzelner Kristallite von einer exakten 90°-Lage im Oberflächenbereich durchaus wünschenswert, da entsprechende Unregelmäßigkeiten zu einer besseren Verflechtung der Schichten miteinander führen.

Fig. 4 zeigt Daten zu Verschleißtests mit Wendeschneidplatten, welche mehrlagige CVD-Beschichtungen mit einem Aufbau gemäß Tabelle 1 hatten. Das Hartmetallsubstrat und die Schneidplattengeometrie waren für alle Wendeschneidplatten ident.

**Tabelle 1: Aufbau und Schichtdicke von mehrlagigen Beschichtungen für Schneidplatten A bis C**

| Schicht | Schichtdicke [µm] | | |
|---|---|---|---|
| | A | B | C |
| TiN | 0,5 | 0,5 | 0,5 |
| MT-TiCN* | 10,0 | 3,0 | 3,0 |
| E-TiCN** | ----- | 4,0 | 7,0 |
| Al₂O₃ | 3,0 | 3,0 | 3,0 |
| TiN | 0,5 | 0,5 | 0,5 |
| Summe | 14,0 | 11,0 | 14,0 |

| | | | |
|---|---|---|---|
| *... Mitteltemperatur-Titancarbonitrid **... Erfindungsgemäß abgeschiedenes Titancarbonitrid | | | |

Die Wendeschneidplatten wurden unter folgenden Versuchsbedingungen bei einer drehenden Bearbeitung des Werkstoffes getestet:
Bearbeiteter Stahl: 34 CrNiMo 6,261 HB
Schnittgeschwindigkeit v_{c}: 280 m/min
Schnitttiefe aₚ: 1,50 mm
Vorschub f: 0,28 mm/U
abgesetzter Schnitt mit Emulsion, jeder Schnitt 30 Sekunden

Wie aus Fig. 4 ersichtlich, weisen unter gleichen Einsatzbedingungen Wendeschneidplatten B und C gegenüber Wendeschneidplatte A bei gleicher Anbindungsschicht an das Hartmetall (0,5 µm TiN) und gleicher äußerer Schicht (0,5 µm TiN) eine wesentlich geringere Verschleißmarkenbreite auf. Nach 20 Schnitten beträgt eine Verschleißmarkenbreite für Wendeschneidplatte A 0,50 µm, wohingegen für Wendeschneidplatte B 0,32 µm und für Wendeschneidplatte C 0,14 µm festgestellt wurden. Im Vergleich der Schichtdicken der Wendeschneidplatten B und A lässt sich feststellen, dass eine erhöhte Verschleißfestigkeit trotz geringerer Schichtdicke erreicht wird. Dies bedeutet fertigungstechnische Vorteile, da bei einem Abscheiden mittels CVD-Verfahren ca. 1 Stunde pro µm Schichtdicke gerechnet werden muss. Nunmehr können also verschleißfestere Beschichtungen in kürzerer Zeit hergestellt werden.

Weitere Versuche zeigten, dass eine erfindungsgemäße Titancarbonitridschicht vorteilhaft auch als äußerste Arbeitsschicht zum Einsatz kommen kann. Bei ansonsten gleichen Schichtaufbau und gleicher Schichtdicke sind Schneidplatten mit einer äußersten Schicht aus erfindungsgemäßem Titancarbonitrid hinsichtlich der Standzeit Schneidplatten mit Mitteltemperatur-Titancarbonitrid als Arbeitsschicht um das 1,5-fache oder mehr überlegen, auch wenn die Mikrohärte geringer ist. Dieser Effekt wird auf die besondere Struktur von erfindungsgemäß hergestellten Titancarbidschichten zurückgeführt.

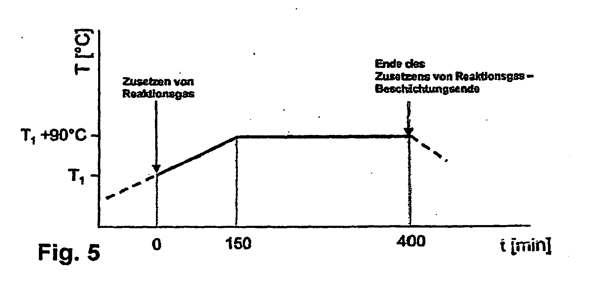

In Fig. 5 ist ein Vorgehen bei einem erfindungsgemäßen Beschichten anhand eines Temperatur-Zeit-Diagramms schematisch und exemplarisch gezeigt: Bei einer Temperatur T₁ des Grundkörpers bzw. der Reaktionskammer von etwa 960 °C (Zeitpunkt "0") wird Reaktionsgas, enthaltend Methan, Stickstoff, Wasserstoff im Verhältnis 1:10:20 und 4 Volumenprozent Titantetrachlorid zugesetzt, wodurch sich, wie angenommen wird, stäbchenförmige Titannitridkeime abscheiden. Anschließend wird die Temperatur bei ständigem Kontakt mit dem Reaktionsgas innerhalb von 150 Minuten stetig auf 1050 °C erhöht; die Temperaturerhöhung von 960 auf 1050 °C kann aber auch schrittweise erfolgen. Schließlich wird das Beschichten bei 1050 °C und gleicher Zusammensetzung des Reaktionsgases für weitere 250 Minuten fortgeführt und danach beendet.

## Patentansprüche

1. Verfahren zum Beschichten eines Werkzeuges oder Werkzeugteiles, insbesondere eines Schneidelementes wie einer Schneidplatte, bei dem ein Grundkörper bereitgestellt und auf diesem eine oder mehrere Schichten aufgebracht werden, wobei zumindest eine Schicht aus einem Titancarbonitrid gebildet wird, wobei das Abscheiden der Schicht aus Titancarbonitrid bei einer Temperatur des Grundkörpers von 850 bis 950 °C begonnen wird, wonach die Temperatur des Grundkörpers um zumindest 40 °C erhöht und das Abscheiden zumindest zeitweise bei erhöhter Temperatur fortgeführt wird, **dadurch gekennzeichnet, dass** die Titancarbonitridschicht mittels eines Methan, Stickstoff und Titantetrachlorid enthaltenden Gases gebildet und abgeschieden wird, wobei das Gas Methan, Stickstoff und Wasserstoff im molaren Verhältnis 1:(8 bis 11):(15 bis 25) enthält und wobei das Gas 1 bis 8 Volumenprozent Titantetrachlorid enthält.

2. Verfahren nach Anspruch 1, **dadurch gekennzeichnet, dass** die Temperatur des Grundkörpers unter fortschreitendem Abscheiden erhöht wird.

3. Verfahren nach Anspruch 1 oder 2, **dadurch gekennzeichnet, dass** die Temperatur des Grundkörpers innerhalb von 350 Minuten, insbesondere 120 Minuten, nach Beginn des Abscheidens auf erhöhte Temperatur gebracht wird.

4. Verfahren nach einem der Ansprüche 1 bis 3, **dadurch gekennzeichnet, dass** nach Erreichen erhöhter Temperatur das Abscheiden für zumindest 60 Minuten fortgeführt wird.

5. Verfahren nach einem der Ansprüche 1 bis 4, **dadurch gekennzeichnet, dass** die erhöhte Temperatur 1010 bis 1040 °C beträgt.

6. Verfahren nach einem der Ansprüche 1 bis 5, **dadurch gekennzeichnet, dass** die Titancarbonitridschicht mittels eines aus Methan, Stickstoff, Wasserstoff und Titantetrachlorid bestehenden Gases abgeschieden wird.

7. Auf einem Gegenstand aufgebrachte Beschichtung mit mindestens einer Titancarbonitridschicht, **dadurch gekennzeichnet, dass** die Titancarbonitridschicht eine Nano-Komposit-Struktur aufweist, welche aus Kristallen mit inhomogener Elementverteilung gebildet ist, wobei die Kristalle in ihrer chemischen Zusammensetzung im Zentrum und im Randbereich unterschiedliche Gehalte an Kohlenstoff und an Stickstoff aufweisen.

8. Beschichtung mit einer Titancarbonitridschicht nach Anspruch 7, **dadurch gekennzeichnet, dass** mindestens zwei Arten von Kristallen mit unterschiedlicher geometrischer Ausformung die Schicht bilden.

9. Beschichtung mit einer Titancarbonitridschicht nach Anspruch 7 oder 8, **dadurch gekennzeichnet, dass** die Schicht aus mindestens einer Art mit sternförmig nadeliger Struktur und mindestens einer Art mit plättchenförmiger Struktur gebildet ist.

10. Beschichtung mit einer Titancarbonitridschicht nach einem der Ansprüche 7 bis 9, **dadurch gekennzeichnet, dass** die Schicht mit Bor, Silicium, Zirkonium, Hafnium, Vanadium oder seltenen Erden dotiert ist.

11. Beschichtung mit einer Titancarbonitridschicht nach einem der Ansprüche 7 bis 10, **dadurch gekennzeichnet, dass** die Kristalle eine mittlere Größe unter 65 nm, vorzugsweise unter 45 nm, aufweisen.

12. Beschichtung mit einer Titancarbonitridschicht nach einem der Ansprüche 7 bis 11, **dadurch gekennzeichnet, dass** die mittlere Größe der Kristalle nach außen hin, also werkstückseitig, erhöht ist.

13. Beschichtung mit einer Titancarbonitridschicht nach einem der Ansprüche 7 bis 12, **dadurch gekennzeichnet, dass** die Schicht eine Zusammensetzung TiCₓN_{y} mit x gleich 0,1 bis weniger als 0,3 und y gleich 0,9 bis mehr als 0,7 aufweist.

14. Beschichtung mit einer Titancarbonitridschicht nach Anspruch 13, **dadurch gekennzeichnet, dass** die Werte x = 0,15 bis 0,20 und y = 0,85 bis 0,80 betragen.

15. Beschichtung mit einer Titancarbonitridschicht nach einem der Ansprüche 7 bis 14, **dadurch gekennzeichnet, dass** die Farbe der Schicht einen gelb-rot Ton mit einer hell-dunkel Struktur, insbesondere mit einer dgl. Aderstruktur aufweist, welche im Schliffbild am Lichtmikroskop auch bei Vergrößerung von 500 -1000-fach erkennbar ist.

16. Werkzeug oder Werkzeugteil, insbesondere Schneidelement wie eine Schneidplatte, umfassend einen Grundkörper mit einer oder mehreren auf diesem aufgebrachten Schichten, wobei mindestens eine Schicht eine Metallcarbonitridschicht ist, **dadurch gekennzeichnet, dass** eine Beschichtung nach einem der Ansprüche 7 bis 15 aufgebracht ist.

17. Werkzeug oder Werkzeugteil nach Anspruch 16, **dadurch gekennzeichnet, dass** nach außen hin, also werkstückseitig, die Carbonitridschicht sternförmig nadelig ausgeformt ist und eine Deckschicht gebildet als Oxidschicht, vorzugsweise eine Aluminiumoxidschicht (Al₂O₃) oder als eine Kohlenstoffschicht, insbesondere Diamantschicht trägt.

## Claims

1. A method for coating a tool or tool component, particularly a cutting element such as a cutting insert, in which a base body is prepared and on this one or a plurality of layers are deposited, wherein at least one layer is formed from a titanium carbonitride, wherein the deposition of the layer made of titanium carbonitride is begun at a temperature of the base body of 850 to 950°C, whereupon the temperature of the base body rises by at least 40°C and the deposition is continued at least temporarily at increased temperature, **characterised in that** the titanium carbonitride layer is formed and deposited by means of a gas containing methane, nitrogen and titanium tetrachloride, wherein the gas contains methane, nitrogen and hydrogen in the molar ratio 1:(8 to 11):(15 to 25) and wherein the gas contains 1 to 8 per cent by volume of titanium tetrachloride.

2. The method according to claim 1, **characterised in that** the temperature of the base body is increased with continuing deposition.

3. The method according to claim 1 or 2, **characterised in that** the temperature of the base body is brought to an elevated temperature within 350 minutes, particularly 120 minutes, following the start of deposition.

4. The method according to any one of claims 1 to 3, **characterised in that** after reaching elevated temperature, the deposition is continued for at least 60 minutes.

5. The method according to any one of claims 1 to 4, **characterised in that** the elevated temperature is 1010 to 1040°C.

6. The method according to any one of claims 1 to 5, **characterised in that** the titanium carbonitride layer is deposited by means of a gas consisting of methane, nitrogen, hydrogen and titanium tetrachloride.

7. A coating with at least one titanium carbonitride layer deposited onto an object, **characterised in that** the titanium carbonitride layer has a nanocomposite structure which is formed from crystals with inhomogeneous element distribution, wherein, in terms of their chemical composition, the crystals have different contents of carbon and of nitrogen in the centre and in the edge region.

8. The coating with a titanium carbonitride layer according to claim 7, **characterised in that** at least two types of crystals with different geometric shaping form the layer.

9. The coating with a titanium carbonitride layer according to claim 7 or 8, **characterised in that** the layer is formed from at least one type with star-shaped acicular structure and at least one type with platelet-like structure.

10. The coating with a titanium carbonitride layer according to any one of claims 7 to 9, **characterised in that** the layer is doped with boron, silicon, zirconium, hafnium, vanadium or rare earths.

11. The coating with a titanium carbonitride layer according to any one of claims 7 to 10, **characterised in that** the crystals have an average size below 65 nm, preferably below 45 nm.

12. The coating with a titanium carbonitride layer according to any one of claims 7 to 11, **characterised in that** the average size of the crystals is increased towards the outside, that is to say on the workpiece side.

13. The coating with a titanium carbonitride layer according to any one of claims 7 to 12, **characterised in that** the layer has a composition TiCₓN_{y}, where x equals 0.1 to less than 0.3 and y equals 0.9 to more than 0.7.

14. The coating with a titanium carbonitride layer according to claim 13, **characterised in that** the values are x = 0.15 to 0.20 and y = 0.85 to 0.80.

15. The coating with a titanium carbonitride layer according to any one of claims 7 to 14, **characterised in that** the colour of the layer has a yellow/red tone with a light/dark structure, particularly with a similar strand structure which can be seen in a microsection on a light microscope even at a magnification of 500-1000 times.

16. A tool or tool component, particularly a cutting element, such as a cutting insert, comprising a base body with one or a plurality of layers deposited on the same, wherein at least one layer is a metal carbonitride layer, **characterised in that** a coating according to any one of claims 7 to 15 is applied.

17. The tool or tool component according to claim 16, **characterised in that** towards the outside, that is to say on the workpiece side, the carbonitride layer is formed in a star-shaped acicular manner and carries a top layer, formed as oxide layer, preferably an aluminium oxide layer (Al₂O₃), or as a carbon layer, particularly a diamond layer.

## Revendications

1. Procédé de revêtement d'un outil ou d'une partie d'un outil, notamment d'un élément de coupe, tel qu'une matrice de découpage, lors duquel un corps de base est mis à disposition et on applique sur ce dernier une ou plusieurs couches, au moins une couche étant créée en un carbonitrure de titane, le dépôt de la couche en carbonitrure de titane étant démarré à une température du corps de base comprise entre 850 et 950 °C, suite à quoi, la température du corps de base est augmentée d'au moins 40 °C et le dépôt est poursuivi au mois en partie à température augmentée, **caractérisé en ce que** la couche de carbonitrure de titane est crée et déposée au moyen d'un gaz contenant du méthane, de l'azote et du tétrachlorure de titane, le gaz contenant du méthane, de l'azote et de l'hydrogène dans une proportion moléculaire de 1:(8 à 11):(15 à 25) et le gaz contenant de 1 à 8 pour cent en volume de tétrachlorure de titane.

2. Procédé selon la revendication 1, **caractérisé en ce qu'**on augmente la température du corps de base au fur et à mesure de l'avancement du dépôt.

3. Procédé selon la revendication 1 ou 2, **caractérisé en ce qu'**en ce que dans un laps de temps de 350 minutes, notamment de 120 minutes après le début du dépôt, on amène la température du corps de base à une température élevée.

4. Procédé selon l'une quelconque des revendications 1 à 3, **caractérisé en ce qu'**après atteinte d'une température élevée, on poursuit le dépôt pendant au moins 60 minutes.

5. Procédé selon l'une quelconque des revendications 1 à 4, **caractérisé en ce que** la température élevée est de 1010 à 1040 °C.

6. Procédé selon l'une quelconque des revendications 1 à 5, **caractérisé en ce qu'**on dépose la couche de carbonitrure de titane au moyen d'un gaz consistant dans du méthane, de l'azote, de l'hydrogène et du tétrachlorure de titane.

7. Revêtement appliqué sur un objet, avec au moins une couche de tétrachlorure de titane, **caractérisé en ce que** la couche de tétrachlorure de titane présente une structure nano-composite qui est formée de cristaux à distribution inhomogène des éléments, les cristaux comportant dans leur composition chimique différentes teneurs en carbone et en azote au centre et dans la zone marginale.

8. Revêtement avec une couche de carbonitrure de titane selon la revendication 7, **caractérisé en ce qu'**au moins deux types de cristaux à différente configuration géométrique forment la couche.

9. Revêtement avec une couche de carbonitrure de titane selon la revendication 7 ou 8, **caractérisé en ce que** la couche est formée d'au moins un type à structure aciculaire en forme d'étoile et d'au moins un type à structure en paillettes.

10. Revêtement avec une couche de carbonitrure de titane selon l'une quelconque des revendications 7 à 9, **caractérisé en ce que** la couche est dopée au bore, au silicium, au zirconium, au hafnium, au vanadium ou aux terres rares.

11. Revêtement avec une couche de carbonitrure de titane selon l'une quelconque des revendications 7 à 10, **caractérisé en ce que** les cristaux sont d'une dimension moyenne inférieure à 65 nm, de préférence inférieure à 45 nm.

12. Revêtement avec une couche de carbonitrure de titane selon l'une quelconque des revendications 7 à 11, **caractérisé en ce que** la dimension moyenne des cristaux est augmentée vers l'extérieur, donc côté de la pièce à usiner.

13. Revêtement avec une couche de carbonitrure de titane selon l'une quelconque des revendications 7 à 12, **caractérisé en ce que** la couche présente une composition TiCₓN_{y} avec x égal à 0, 1 à moins de 0,3 et y égal à 0,9 à plus de 0,7.

14. Revêtement avec une couche de carbonitrure de titane selon la revendication 13, **caractérisé en ce que** les valeurs sont de x = 0,15 à 0,20 et y = 0,85 à 0,80.

15. Revêtement avec une couche de carbonitrure de titane selon l'une quelconque des revendications 7 à 14, **caractérisé en ce que** la teinte de la couche est un ton rouge jaunâtre avec une structure claire-obscure, notamment avec une structure veineuse telle qu'elle est identifiable à l'image de l'échantillon poli au microscope optique également avec un agrandissement de 500 - 1000.

16. Outil ou partie d'outil, notamment élément de coupe, tel qu'une matrice de découpe, comprenant un corps de base avec une ou plusieurs couches appliquées sur ce dernier, au moins une couche étant une couche en carbonitrure de métal, **caractérisé en ce qu'**une couche est appliquée selon l'une quelconque des revendications 7 à 15.

17. Outil ou partie d'outil selon la revendication 16, **caractérisé en ce que** vers l'extérieur, donc côté pièce à usiner, la couche de carbonitrure est conformée en structure aciculaire en forme d'étoile et porte une couche de couverture sous la forme d'une couche d'oxyde, de préférence une couche en oxyde d'aluminium (Al₂O₃) ou d'une couche en carbone, notamment une couche en diamant.
